Europäisches Patentamt

European Patent Office

Office européen des brevets

Veröffentlichungsnummer: **0 211 234**
**A2**

## EUROPÄISCHE PATENTANMELDUNG

Anmeldenummer: **86108964.7**

Int. Cl.⁴: **H01L 33/00** , **H01L 27/15**

Anmeldetag: **02.07.86**

Priorität: **02.08.85 DE 3527720**

Veröffentlichungstag der Anmeldung:
**25.02.87 Patentblatt 87/09**

Benannte Vertragsstaaten:
**FR GB IT NL**

Anmelder: **TELEFUNKEN electronic GmbH**
**Theresienstrasse 2**
**D-7100 Heilbronn(DE)**

Erfinder: **Gillessen, Klaus, Dr. Dipl.-Phys.**
**Im Fuchsloch 13**
**D-7101 Untergruppenbach(DE)**

Vertreter: **Maute, Hans-Jürgen, Dipl.-Ing.**
**TELEFUNKEN electronic GmbH**
**Theresienstrasse 2**
**D-7100 Heilbronn(DE)**

Lichtemittierendes Halbleiterbauelement.

Bei einem lichtemittierenden Halbleiterbauelement mit einem Substrat und zwei auf dem Substrat befindlichen Halbleiterschichten vom entgegengesetzten Leitungstyp ist eine Halbleiterzone vorgesehen, die sich von der Halbleiteroberfläche aus durch die obere Halbleiterschicht bis zur darunter befindlichen zweiten Halbleiterschicht oder in die zweite Halbleiterschicht erstreckt. Diese Halbleiterzone ist derart ausgebildet, daß sie den Bereich des pn-Überganges in lateraler Richtung in der Schichtebene begrenzt, den die beiden Halbleiterschichten miteinander bilden.

Fig.1

## Lichtemittierendes Halbleiterbauelement

Die Erfindung betrifft ein lichtemittierendes Halbleiterbauelement mit einem Substrat und zwei auf dem Substrat befindlichen Halbleiterschichten, wobei der Leitungstyp der einen Halbleiterschicht entgegengesetzt zum Leitungstyp der anderen Halbleiterschicht ist (entgegengesetzter Leitungstyp).

Anordnungen mit lichtemittierenden Dioden - (LED) werden heute für sehr viele verschiedenartige Anwendungen eingesetzt. Zwei Anwendungsmöglichkeiten haben in der letzten Zeit besonders an Bedeutung gewonnen und zwar kleinflächige LED's (aktive Fläche typisch 50 $\mu$m Durchmesser) für Lichtleiteranordnungen und LED-Zeilen mit hoher Auflösung (10 bis 16 LED's pro mm) für elektrophotographische Drucker.

Für beide Fälle weisen die bekannten Verfahren zur Herstellung von LED's bestimmte Mängel auf: bei einer Herstellung mittels Gasphasenepitaxie von GaAs $_{1-x}$P$_x$ und p-Diffusion der aktiven Gebiete können zwar in einfacher Weise kleinflächige und eng benachbarte LED's hergestellt werden, jedoch ist die Strahlungsleistung der erhaltenen Elemente verhältnismäßig gering. Beispielsweise emittiert eine typische LED aus GaAs $_{0,6}$P$_{0,4}$ bei einem Betriebsstrom von 10 mA eine Leistung von etwa 25 $\mu$W. Mit einer anderen bekannten Herstellungsmethode, der Flüssigphasenepitaxie von Ga$_{1-x}$Al$_x$As, können rote LED's erheblich höherer Leistung erhalten wer den, die bei gleichen Bedingungen über 100 $\mu$W emittieren. Bei dieser Technik ist es jedoch nachteilig, daß der aktive pn-Übergang auf der ganzen Halbleiterscheibe entsteht. Dadurch wird die Herstellung kleinflächiger und eng benachbarter LED's erschwert und erfordert z. B. die Anwendung der Mesatechnik, so daß Leiterbahnen zur Stromzuführung nur mit erheblichen Schwierigkeiten angebracht werden können. Alternativ könnte auch das Verfahren der selektiven Flüssigphasenepitaxie eingesetzt werden, das aber wenig entwickelt ist und keine hohe Herstellungsausbeute erlaubt.

Der Erfindung liegt die Aufgabe zugrunde, ein lichtemittierendes Halbleiterbauelement anzugeben, welches ein kleinflächiges aktives Gebiet aufweist, welches hohe Leistung emittiert und welches mit relativ einfachen Mitteln herstellbar ist. Diese Aufgabe wird bei einem lichtemittierenden Halbleiterbauelement der eingangs erwähnten Art nach der Erfindung durch die kennzeichnenden Merkmale des Anspruchs 1 gelöst.

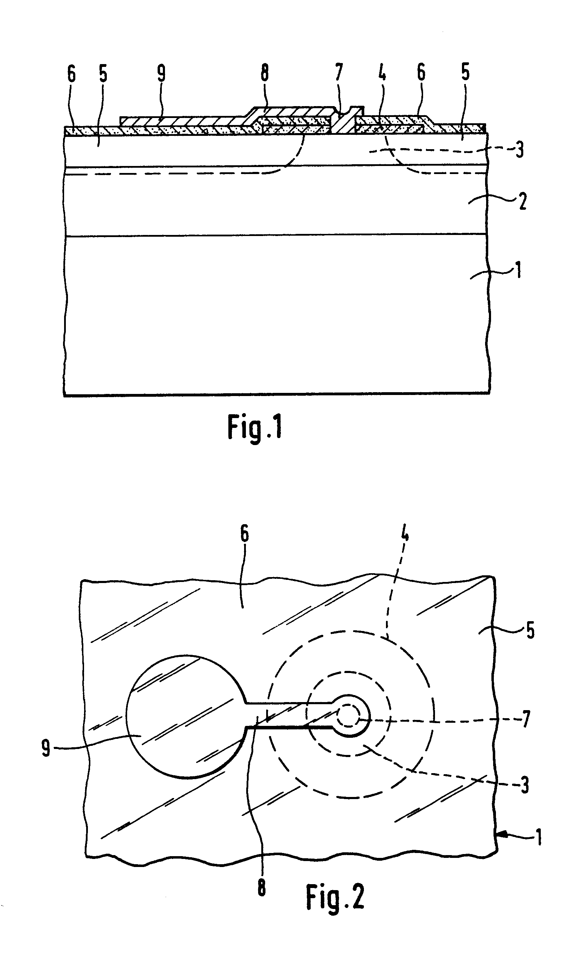

Die Erfindung wird im folgenden anhand von zwei Ausführungsbeispielen erläutert, wobei das erste Ausführungbeispiel ein kleinflächiges Einzelelement für faseroptische Anwendungen ist. Die Herstellung des ersten Ausführungsbeispiels wird anhand der Figuren 1 und 2 beschrieben.

Gemäß der Figur 1 wird zur Herstellung eines lichtemittierenden Halbleiterbauelements auf einem Substrat 1 aus p-leitendem Galliumarsenid eine erste Schicht 2 aus Galliumaluminiumarsenid Ga$_{1-x}$Al$_x$ As mittels Flüssigphasenepitaxie abgeschieden, die ebenfalls p-leitend ist, z. B. durch Dotierung mit Zink im Bereich $10^{18}$ bis $10^{19}$ cm$^{-3}$, und die eine Dicke von 10 bis 50 $\mu$m, vorzugsweise um 20 $\mu$m aufweist. Der Aluminiumgehalt x der Schicht 2 wird je nach gewünsch ter Wellenlänge im Bereich 0 bis 45 % gewählt. So entspricht z. B. einem Aluminiumgehalt von 10 % eine Wellenlänge von etwa 800 nm und einem Aluminiumgehalt von 40 % eine Wellenlänge von etwa 650 nm. Auf der Schicht 2 wird gemäß den Figuren 1 und 2 (Figur 1 zeigt den Querschnitt, Figur 2 die Draufsicht) eine zweite Schicht 3 ebenfalls aus Galliumaluminiumarsenid Ga$_{1-y}$Al$_y$As auf die gleiche Weise abgeschieden, die n-leitend ist, z. B. durch Dotierung mit Tellur im Bereich $10^{17}$ bis $10^{18}$ cm$^{-3}$ und die eine Dicke von 3 bis 20 $\mu$m, vorzugsweise um 5 $\mu$m aufweist. Der Aluminiumgehalt y der Schicht 3 wird größer als der Aluminiumgehalt x der Schicht 2 eingestellt, und zwar vorzugsweise so, daß die Beziehung y = x + 30 % annähernd erfüllt ist. Auf die Oberfläche der Schicht 3 wird eine Maskierungsschicht 4, z. B. aus Siliziumnitrid aufgebracht und mit bekannten photolithographischen und Ätzverfahren so strukturiert, daß für jedes Element ein beispielsweise kreisförmiger Bereich von etwa 60 $\mu$m Durchmesser vorgesehen ist. Die Figur 1 zeigt aus Darstellungsgründen die Herstellung von nur einem Bauelement, während in Wirklichkeit natürlich gleichzeitig eine Vielzahl von Einzelelementen hergestellt wird. Durch Eindiffusion von Zink nach bekannten Verfahren werden nun p-leitende Zonen 5 erzeugt, deren Tiefe bei einer Dicke der zweiten Epitaxieschicht 3 von 5 $\mu$m beispielsweise 7 $\mu$m beträgt. Nach diesem Diffusionsprozeß sind in der Schicht 3 nur noch die Gebiete unter den kreisförmigen Bereichen der Maskierungsschicht 4 n-leitend. Diese Gebiete haben einen Durchmesser von etwa 45 $\mu$m. Nun wird eine Isolationsschicht 6 aufgebracht, die z. B. aus Siliziumnitrid oder Siliziumdioxid besteht. In diese Schicht werden nach bekannten Verfahren Kontaktöffnungen 7 eingeätzt, die oberhalb des n-leitenden Gebiets der Schicht 3 angeordnet sind. Schließlich wird eine metallische Kontaktschicht 8 aufgebracht und auf bekannte Weise strukturiert, so daß eine Bond fläche 9 entsteht, die mit dem n-leitenden Gebiet der Schicht 3 verbunden ist. Die weiteren Herstellungsschritte sind bekannt und brauchen hier nicht mehr beschrieben zu werden. Sie umfassen insbesondere die Herstellung eines metallischen Kontakts zum Substrat 1 und die Zerteilung der Halbleiterscheibe in Einzelelemente.

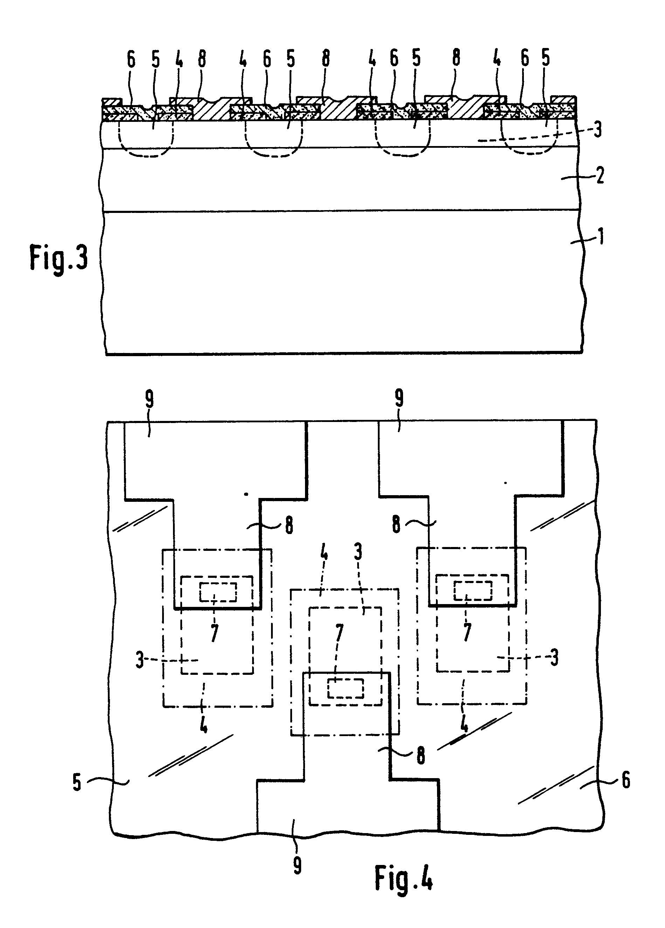

Das zweite Ausführungsbeispiel wird im folgenden anhand der Figuren 3 (Querschnitt) und 4 - (Draufsicht) beschrieben. Substrat 1, erste Schicht 2 und zweite Schicht 3 entsprechen dabei vollständig dem ersten Ausführungsbeispiel. Auch die weiteren Herstellungsschritte sind dem ersten Ausführungsbeispiel sehr ähnlich, die Strukturen unterscheiden sich lediglich in lateraler Richtung, d. h. parallel zu den Schichtflächen. Aus der Maskierungsschicht 4 werden für jedes Element der herzustellenden monolithischen LED-Zeile rechteckige Bereiche gebildet. Die p-leitenden Zonen 5 bilden isolierende Gebiete zwischen den unter den rechteckigen Bereichen der Maskierungsschicht 4 liegenden n-leitenden Gebieten. Die Kontaktöffnungen 7 in der Isolierungsschicht 6 verbinden die metallische Kontaktschicht 8 mit den n-leitenden Gebieten. Die Bondflächen 9 sind alternierend zur einen und anderen Seite der LED-Zeile gelegt, um auch bei geringer Größe und kleinem Abstand der LED-Elemente genügend Raum zum Anbringen der Bonddrähte vorzusehen. Für eine Auflösung der LED-Zeile von 16 Elementen pro mm Länge (Rastermaß 62,5 $\mu$m) kann die Breite der n-leitenden Gebiete z. B. etwa 40 $\mu$m betragen.

## Ansprüche

1) Lichtemittierendes Halbleiterbauelement mit einem Substrat und zwei auf dem Substrat befindlichen Halbleiterschichten vom entgegengesetzten Leitungstyp, dadurch gekennzeichnet, daß eine Halbleiterzone vorgesehen ist, die sich von der Halbleiteroberfläche aus durch die obere Halbleiterschicht bis zur darunter befindlichen zweiten Halbleiterschicht oder in die zweite Halbleiterschicht erstreckt, und daß die Halbleiterzone derart ausgebildet ist, daß sie den Bereich des pn-Überganges in lateraler Richtung in der Schichtebene begrenzt, den die beiden Halbleiterschichten miteinander bilden.

2) Lichtemittierendes Halbleiterbauelement nach Anspruch 1, dadurch gekennzeichnet, daß die Halbleiterzone denjenigen Leitungstyp aufweist, den die untere der beiden übereinander befindlichen Halbleiterschichten besitzt.

3) Lichtemittierendes Halbleiterbauelement nach Anspruch 1 oder 2, dadurch gekennzeichnet, daß die Halbleiterzone eine Diffusionszone ist.

4) Lichtemittierendes Halbleiterbauelement nach einem der Ansprüche 1 bis 3, dadurch gekennzeichnet, daß der durch die Halbleiterzone begrenzte stromführende Bereich einen kreisförmigen oder einen rechteckförmigen Querschnitt aufweist.

5) Lichtemittierendes Halbleiterbauelement nach einem der Ansprüche 1 bis 4, dadurch gekennzeichnet, daß der stromführende Bereich im mittleren Bereich des Halbleiterbauelementes liegt.

6) Lichtemittierendes Halbleiterbauelement nach einem der Ansprüche 1 bis 5, dadurch gekennzeichnet, daß mehrere stromführende Bereiche vorgesehen sind.

7) Lichtemittierendes Halbleiterbauelement nach einem der Ansprüche 1 bis 6, dadurch gekennzeichnet, daß der stromführende Bereich kleinflächig ausgebildet ist und in Richtung der Schichtebene eine Ausdehnung von kleiner als 100 $\mu$m aufweist.

8) Lichtemittierendes Halbleiterbauelement nach einem der Ansprüche 1 bis 7, dadurch gekennzeichnet, daß die stromführenden Bereiche in einer Richtung in einem Raster von weniger als 100 $\mu$m angeordnet sind.

9) Lichtemittierendes Halbleiterbauelement nach einem der Ansprüche 1 bis 8, dadurch gekennzeichnet, daß die Halbleiterschichten aus Galliumaluminiumarsenid bestehen.

Fig.1

Fig.2

Fig.3

Fig.4